(19) Europäisches Patentamt
European Patent Office
Office européen des brevets

(11)    **EP 2 691 953 B1**

(12)    **FASCICULE DE BREVET EUROPEEN**

(45) Date de publication et mention
de la délivrance du brevet:
**29.07.2015   Bulletin 2015/31**

(51) Int Cl.:
***G10L 19/04*** *(2013.01)*      ***G10L 25/90*** *(2013.01)*

(21) Numéro de dépôt: **12717393.8**

(22) Date de dépôt: **27.03.2012**

(86) Numéro de dépôt international:
**PCT/FR2012/050637**

(87) Numéro de publication internationale:
**WO 2012/131247 (04.10.2012 Gazette 2012/40)**

(54) **TRAITEMENT DANS LE DOMAINE CODE D'UN SIGNAL AUDIO CODE PAR CODAGE MICDA**

VERARBEITUNG EINES CODIERTEN AUDIOSIGNALS IM KODIERTEN BEREICH DURCH MICDA-KODIERUNG

PROCESSING AN ENCODED AUDIO SIGNAL IN THE ENCODED DOMAIN BY MICDA CODING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.03.2011   FR 1152596**

(43) Date de publication de la demande:
**05.02.2014   Bulletin 2014/06**

(73) Titulaire: **Orange**
**75015 Paris (FR)**

(72) Inventeurs:
• **CORMIER, Adrien**
**F-17230 Villedoux (FR)**
• **KOVESI, Balazs**
**F-22300 Lannion (FR)**

• **LAMBLIN, Claude**
**F-22730 Tregastel (FR)**

(74) Mandataire: **Froger, Marie-Hélène**
**Orange**
**R&D/PIV/Brevets**
**38-40, rue du Général Leclerc**
**92794 Issy-Les-Moulineaux cedex 09 (FR)**

(56) Documents cités:
• **RAFILA K S ET AL: "Voice/unvoiced/mixed excitation classification of speech using the autocorrelation of the output of an ADPCM system", 19890824; 19890824 - 19890826, 24 août 1989 (1989-08-24), pages 537-540, XP010088173,**
• **"7 kHz audio-coding within 64 kbit/s; G.722 (11/88)", ITU-T STANDARD, INTERNATIONAL TELECOMMUNICATION UNION, GENEVA ; CH, no. G.722 (11/88), 25 novembre 1988 (1988-11-25), pages 1-75, XP017460950,**

EP 2 691 953 B1

**Description**

La présente invention se rapporte aux traitements des signaux numériques codés. Ces signaux codés sont destinés à prendre place dans des applications de transmission ou de stockage de signaux multimédias tels que les signaux audio (parole et/ou sons).

La présente invention se rapporte plus particulièrement aux signaux codés selon une méthode de codage adaptatif de forme d'onde comme la technologie MICDA (pour « Modulation par Impulsions et codage différentiel adaptatif ») ou ADPCM (pour « Adaptative Differential Pulse Code Modulation» en anglais).

La technologie MICDA est une technique de compression des signaux multimédias. Les exemples de codeurs utilisant la technologie MICDA les plus connus et les plus utilisés sont deux codeurs de parole, normalisés à l'UIT-T : le codeur UIT-T G.726 pour des signaux en bande téléphonique (ou bande étroite) échantillonnés à 8 kHz (codeur DECT pour « Digital Enhanced Cordless Telephone » en anglais) et le codeur UIT-T G.722 pour des signaux en bande élargie échantillonnés à 16 kHz (codeur voix HD pour la VoIP).

Le codage MICDA est un codage prédictif où l'échantillon courant est prédit par un prédicteur adaptatif de type ARMA (pour «Auto Régressive Moving Average» en anglais) à partir des valeurs décodées passées. En utilisant les valeurs décodées, le décodeur peut faire la même prédiction que l'encodeur. L'adaptation du prédicteur est également faite à partir des valeurs décodées (du signal décodé et de l'erreur de prédiction décodée), échantillon par échantillon, sans transmission d'information supplémentaire.

L'encodeur MICDA quantifie la différence entre la prédiction de l'échantillon courant et la vraie valeur de l'échantillon courant (l'erreur de prédiction) en utilisant un quantificateur scalaire adaptatif. L'amplitude codée de l'erreur de prédiction est composée de 2 parties : une partie constante stockée en mémoire ROM indexée par les indices de quantification scalaire et un facteur adaptatif multiplicatif (dans le domaine linéaire) appelé facteur d'échelle, dont l'adaptation est faite sans transmission d'information supplémentaire, échantillon par échantillon, en fonction de l'indice de quantification transmis. Dans le flux binaire (bitstream en anglais) MICDA, on transmet donc uniquement les indices de quantification scalaire obtenus en quantifiant l'erreur de prédiction échantillon par échantillon. Ces indices de quantification scalaire se décomposent en un bit de signe sign(n) et un indice de quantification d'amplitude I(n).

Pour décoder le flux binaire, le décodeur effectue une quantification inverse échantillon par échantillon de l'erreur de prédiction utilisant le quantificateur adaptatif inverse. Le décodeur fait également la même prédiction de l'échantillon courant que celle effectuée à l'encodeur, en utilisant le même prédicteur adaptatif ARMA (en l'absence d'erreurs de transmission) adapté échantillon par échantillon. En cas d'erreurs de transmission, le prédicteur et le quantificateur au décodeur divergent de ceux à l'encodeur. Grâce à l'utilisation de facteurs d'oubli ils re-convergent généralement en quelques millisecondes. La valeur décodée de l'échantillon courant est obtenue en additionnant la prédiction et la valeur déquantifiée de l'erreur de prédiction.

Dans une chaine de transmission, outre le codage et décodage, d'autres procédures de traitements de signal peuvent être effectuées. On peut citer par exemple : les traitements effectués dans les ponts de conférence pour mixer ou commuter tout ou une partie des flux entrants pour générer des flux sortants, ceux effectués dans des ponts de conférence, des passerelles ou des périphériques pour dissimuler des paquets ou trames perdus (« PLC: Packet Loss Concealment » en anglais) ou pour ajuster temporellement le signal (« time scaling » en anglais), ou bien encore les traitements dans les serveurs ou les passerelles de communication pour effectuer une discrimination de contenus ou de voix.

Beaucoup de ces traitements travaillent dans le domaine du signal décodé, ce qui peut nécessiter après traitement un ré-encodage. C'est le cas par exemple, pour les signaux traités dans les ponts de conférence (par exemple pont à mixage) ou dans certains buffers de gigue (e.g. DECT). La trame compressée arrive sous un premier format de codage, elle est décompressée, le signal décodé est analysé pour extraire les données nécessaires au traitement (e.g. paramètres et signaux intermédiaires), puis le signal décodé est traité avec les données analysées, et le signal traité est alors re-compressé sous un format accepté par la suite de la chaine de communication.

Il y a donc une mise en cascade d'un décodeur et d'un codeur, communément appelée un tandem. Cette solution est très coûteuse en complexité (essentiellement à cause du recodage) et elle dégrade la qualité, car le second codage se fait sur un signal décodé, qui est une version déjà dégradée du signal original, les dégradations s'accumulant. Par ailleurs, une trame peut rencontrer plusieurs tandems avant d'arriver à destination. On imagine aisément le coût en calcul et la perte de qualité qu'induit un tel système. De plus, les retards liés à chaque opération de tandem s'accumulent et peuvent nuire à l'interactivité des communications.

Pour certains équipements, le surcoût en mémoire et en complexité pour héberger un encodeur et/ou un décodeur peut être prohibitif. Il se peut aussi que le décodeur ne soit pas implanté dans des équipements où le traitement doit être effectué, comme par exemple les ponts à commutation ou les buffers de gigue.

Certains décodeurs déportés sont dans des terminaux de faible capacité qui ne sont pas aptes à effectuer de tels traitements, c'est le cas par exemple des terminaux DECT reliés à des passerelles domestiques plus communément appelées Boxes.

Pour remédier à ces inconvénients, il existe des procédures de traitement sans décodage complet du signal.

Ainsi, pour des traitements de type dissimulation d'erreurs, il existe des procédures de dissimulation d'erreurs dans le domaine codé, très peu complexes. De telles techniques sont par exemple décrites dans l'annexe A à la recommandation UIT-T G.191 pour des techniques de dissimulation d'erreurs adaptées au codeur G.722. Elles consistent à remplir une trame codée soit avec des indices correspondant à un signal mis à zéro sur toute la durée de la trame soit simplement à une répétition du flux binaire de la trame précédente. Cependant, ces techniques sont de moindre qualité comparativement aux techniques de dissimulations d'erreur décrites dans les appendices III et IV de la norme UIT-T G.722. Dans ces appendices, il est en effet nécessaire d'analyser le signal décodé pour extraire diverses informations sur le signal à reconstruire comme par exemple, la présence ou l'absence d'activité vocale, le degré de stationnarité du signal, la nature du signal, sa période fondamentale, etc...

Ces informations sont, pour certains codeurs, par exemple, les codeurs par analyse par synthèse (CELP pour «Code Excited Linear Prediction» en anglais), estimées à l'encodeur et codées pour être transmises dans le flux binaire. C'est le cas par exemple de la période de pitch.

Ainsi, il est possible pour ce type de codeur, d'exploiter ces informations codées pour effectuer un traitement dans le domaine codé. C'est le cas par exemple de la technique décrite dans la demande de brevet WO 2009/010831 où un traitement dans le domaine codé de type ajustement temporel est proposé pour la technique de compression par analyse-synthèse CELP.

Ce type de traitement dans le domaine codé ne peut pas s'appliquer aux techniques de codage MICDA, car contrairement à la technologie CELP, les paramètres utilisés dans ces traitements ne sont pas calculés par l'encodeur MICDA et ne sont donc pas présents dans le flux binaire MICDA.

Le document "Voice/unvoiced/mixed excitation classification of speech using the autocorrelation of the output of an ADPCM system", Rafila K.S et Dawoud D.S, Systems Engineering, 1989, IEEE International Conference on, propose une méthode d'analyse d'un signal audio codé MICDA en utilisant les indices de quantification.

Il existe donc un besoin d'effectuer des traitements de bonne qualité dans le domaine codé pour des signaux codés par la technologie de codage MICDA sans nécessiter de décodage, même partiel, du signal.

La présente invention améliore la situation.

A cet effet, elle propose selon la revendication 1 un procédé de traitement d'un signal audio codé en un flux binaire par un codage prédictif de type MICDA. Le procédé est remarquable en ce qu'il comporte les étapes suivantes :

- détermination d'un signal estimé à partir des indices de quantification du flux binaire, la détermination étant effectuée pour un échantillon courant par:
- obtention d'un paramètre d'adaptation associé à l'indice de quantification pour l'échantillon courant ;
- calcul d'un signal estimé pour l'échantillon courant à partir du paramètre d'adaptation déterminé, du signal estimé pour l'échantillon précédent et d'un facteur d'oubli prédéfini;
- détermination de paramètres non codés représentatifs dudit signal audio, à partir dudit signal estimé;
- traitement dudit signal audio codé en utilisant les paramètres déterminés.

Ainsi, à partir du flux binaire de type MICDA, l'invention permet de déterminer un signal estimé à partir duquel, les paramètres utiles pour le traitement seront déterminés. Il n'est donc pas nécessaire de décoder le signal pour obtenir ces paramètres. Ce procédé est donc de moindre complexité et peut s'effectuer de façon déportée du décodeur.

L'obtention des paramètres de traitement représentatifs du signal permet de plus, d'obtenir des traitements de bonne qualité adaptés au signal.

Le signal ainsi estimé est très représentatif du signal à coder. Une analyse de ce signal estimé suffit pour déterminer des paramètres non codés de ce signal.

Dans un mode particulier de réalisation, le paramètre d'adaptation est défini dans une étape préalable, de telle sorte que sa valeur respecte la propriété d'accroissement monotone avec les valeurs quantifiées d'amplitude correspondant aux indices de quantification.

Dans un mode avantageux de réalisation, le paramètre d'adaptation est obtenu en temps réel par simple décalage binaire et soustraction à partir de l'indice de quantification.

Ainsi, il n'est pas nécessaire de stocker les paramètres d'adaptation associés aux indices de quantification puisqu'ils sont obtenus directement de façon simple et en temps réel, des indices de quantification.

Dans un mode de réalisation particulier, le signal estimé est déterminé selon l'équation :

$$se(n) = V * se(n\text{-}1) + M(I(n\text{-}1))$$

où se(n) représente le signal estimé pour l'échantillon courant, se(n-1) le signal estimé de l'échantillon précédent, M(I(n-1)) le paramètre d'adaptation en fonction de l'indice de quantification de l'échantillon précédent et V un facteur d'oubli avec une variable inférieure à 1.

Ce type d'équation permet d'obtenir un signal estimé qui suit l'allure du signal codé.

Ainsi, l'analyse du signal estimé permet de déterminer des paramètres compris dans une liste non exhaustive comprenant :

- l'énergie du signal audio ;
- la périodicité ou non du signal audio ;
- la classification du signal audio ;
- la période fondamentale du signal audio ;
- la position temporelle des impulsions glottiques ;
- l'activité vocale.

Selon des modes différents de réalisation, le traitement du signal audio codé peut-être de type :

- discrimination de locuteurs et en cas de détection d'une voix indésirable sa réduction au silence dans le domaine codé ;
- détection de non activité vocale et remplacement du flux binaire correspondant par un flux binaire obtenu par codage d'un bruit de confort à un niveau plus faible.

Ces traitements ne sont que des exemples non limitatifs. Bien d'autres types de traitements pour lesquels des paramètres du signal audio peuvent être utiles, sont bien évidemment aussi possibles.

L'invention se rapporte également selon la revendication 8 à un dispositif de traitement d'un signal audio codé en un flux binaire par un codage prédictif de type MICDA, remarquable en ce qu'il comporte :

- un module de détermination d'un signal estimé à partir des indices de quantification du flux binaire, apte à mettre en oeuvre les étapes suivantes, pour un échantillon courant:
- obtention d'un paramètre d'adaptation associé à l'indice de quantification pour l'échantillon courant;
- calcul d'un signal estimé pour l'échantillon courant à partir du paramètre d'adaptation déterminé, du signal estimé pour l'échantillon précédent et d'un facteur d'oubli prédéfini;
- un module d'analyse pour déterminer des paramètres non codés représentatifs dudit signal audio, à partir dudit signal estimé;
- un module de traitement dudit signal audio codé en utilisant les paramètres déterminés.

Elle peut se rapporter par exemple à un serveur, une passerelle de conmmnication ou à un pont de commutation comprenant le dispositif décrit.

L'invention se rapporte selon la revendication 10 à un programme informatique comportant des instructions de code pour la mise en oeuvre des étapes du procédé de traitement tel que décrit, lorsque ces instructions sont exécutées par un processeur.

Enfin, l'invention se rapporte à un support de stockage, lisible par un processeur, intégré ou non au dispositif de traitement, éventuellement amovible, mémorisant un programme informatique mettant en oeuvre un procédé de traitement tel que décrit précédemment.

D'autres caractéristiques et avantages de l'invention apparaîtront plus clairement à la lecture de la description suivante, donnée uniquement à titre d'exemple non limitatif, et faite en référence aux dessins annexés, sur lesquels:

- la figure 1 illustre une chaine de codage/décodage MICDA dans laquelle vient s'insérer le dispositif de traitement mettant en oeuvre le procédé de traitement selon l'invention ;
- la figure 2 illustre une comparaison entre le signal estimé et le signal audio non codé montrant ainsi les possibilités d'obtention de paramètres de traitement adaptés au signal, selon l'invention ;
- la figure 3 illustre une partie agrandie de la figure 2 montrant une représentation de paramètres de traitement que l'on peut déterminer à partir du signal estimé selon l'invention ; et
- la figure 4 illustre une configuration matérielle particulière d'un dispositif de traitement ou système apte à une mise en oeuvre du procédé selon l'invention.

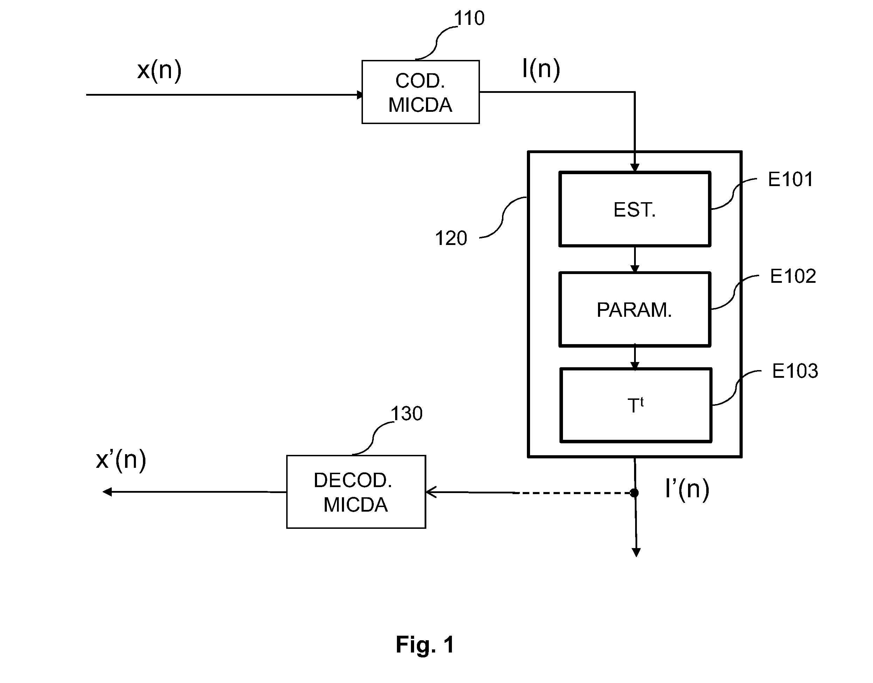

La **figure 1** montre ainsi une chaine de codage/décodage MICDA dans laquelle vient s'insérer l'invention.

Le signal d'entrée x(n) est codé en 110 par un module de codage MICDA comme décrit par exemple dans les recommandations UIT-T G.722 ou G.726. A la sortie de ce module de codage, des indices de quantification (bit de signe sign(n) et indice de quantification d'amplitude I(n)) sont obtenus échantillon par échantillon. En utilisant par exemple k bits par échantillon on peut coder $2^{k-1}$ différentes amplitudes, I(n) se compose donc de k-1 bits. A noter que dans certains codeurs le codage du bit de signe et des bits d'amplitude est fait de façon conjointe (sans faire de distinction entre bit de signe et bits d'amplitude, comme par exemple dans le codeur UIT-T G.722). Dans ce cas l'indice d'amplitude I(n) et le bit de signe sign(n) peuvent être facilement trouvés à partir de la représentation conjointe, par exemple par simple lecture d'un tableau de correspondance. Dans les exemples donnés dans ce document, pour la simplicité de la notation, nous supposons également que les valeurs quantifiées d'amplitude augmentent d'une façon monotone avec l'indice de quantification d'amplitude (l'indice 0 correspond à la plus petite amplitude), mais l'invention s'applique naturellement aux autres cas possibles également. Dans ces autres cas on peut par exemple réordonner les valeurs avant d'appliquer l'invention.

Le dispositif de traitement 120 reçoit en entrée les indices de quantification d'amplitude I(n).

Dans une étape E101, un module « EST. », met en oeuvre une étape de détermination d'un signal estimé se(n), à partir de ces indices de quantification d'amplitude I(n). Par exemple, le signal estimé est obtenu en mettant à jour sa valeur précédente se(n-1) en utilisant un paramètre d'adaptation (M(I(n-1)) qui dépend de l'indice de quantification scalaire d'amplitude précédent (I(n-1)). Dans ce cas, pour un indice de quantification d'amplitude I(n), le module « EST. » obtient donc un paramètre d'adaptation M(I(n)) associé à cet indice. Le paramètre d'adaptation M(I(n)) peut être multiplicatif ou additif.

Ce paramètre d'adaptation a été défini par exemple dans une étape préalable et stocké en association avec la valeur de l'indice de quantification d'amplitude dans une table. Avantageusement, le paramètre d'adaptation croît avec la valeur d'amplitude associée à l'indice de quantification d'amplitude. Dans le cas d'un paramètre d'adaptation multiplicatif, il est inférieur à 1 pour les indices correspondant à une valeur quantifiée d'amplitude faible et supérieur à 1 pour les indices correspondant à une valeur quantifiée d'amplitude forte. Dans le cas d'un paramètre d'adaptation additif il est inférieur à 0 pour les indices correspondant à une valeur quantifiée d'amplitude faible et supérieur à 0 pour les indices correspondant à une valeur quantifiée d'amplitude forte).

Dans un mode de réalisation avantageux le paramètre d'adaptation additif correspondant à l'indice de quantification d'amplitude de l'échantillon précédent (M(I(n-1))) est additionné, à la valeur de l'échantillon précédent du signal estimé (se(n-1)) pour donner la valeur de l'échantillon courant (se(n)). Le paramètre d'adaptation déduit de l'indice de quantification d'amplitude représente ainsi la variation entre l'échantillon courant et l'échantillon précédent du signal estimé.

$$se'(n) = se'(n-1) + M(I(n-1)) \qquad (1)$$

Dans un exemple de réalisation où l'indice de quantification d'amplitude est codé sur k-1=3 bits, le tableau 1 suivant donne un exemple des valeurs possibles de ce paramètre d'adaptation additif en fonction de l'indice de quantification I(n).

**Tableau 1 : exemple de valeurs du paramètre d'adaptation additif en fonction de l'indice de quantification**

| indice d'amplitude I(n) | 0 | 1 | 2 | 3 | 4 | 5 | 6 | 7 |
|---|---|---|---|---|---|---|---|---|
| paramètre d'adaptation M(I(n)) | -3 | -2 | 0 | 4 | 12 | 28 | 60 | 124 |

Nous rappelons que dans le tableau 1 nous supposons que les valeurs quantifiées d'amplitude augmentent d'une façon monotone avec l'indice de quantification d'amplitude. Les valeurs M(I(n)) peuvent bien évidemment être différentes pourvu qu'elles gardent la propriété d'accroissement monotone avec les valeurs quantifiées d'amplitude correspondant aux indices de quantification et qu'elles respectent la restriction concernant les signes de ces valeurs (négatif pour les indices correspondant à une valeur quantifiée d'amplitude faible et positif pour les indices correspondant à une valeur quantifiée d'amplitude forte).

Il est encore plus avantageux de choisir des valeurs M(I(n-1)) d'une telle façon qu'on puisse les obtenir en temps réel à partir de l'indice de quantification d'amplitude I(n) par des opérations mathématiques simples. Ainsi le stockage de ce tableau n'est plus nécessaire (tableau virtuel) diminuant ainsi les besoins en mémoire ROM du dispositif selon l'invention. Dans le cas du tableau 1 les valeurs de l'exemple donné par ce tableau 1 ont été obtenues par l'équation :

$$M(I(n-1)) = (1 << I(n-1)) - 4$$

où << symbolise le décalage binaire à gauche.

De façon à obtenir un signal estimé qui converge rapidement après par exemple une éventuelle erreur de transmission, un facteur d'oubli est défini pour pondérer le signal estimé de l'échantillon précédent. Ce facteur d'oubli est une variable, en général d'une valeur inférieure à un et peut par exemple être choisie avec une valeur de 0.99.

Dans un mode de réalisation de l'invention, le signal estimé est alors calculé en E101 selon l'équation suivante :

$$se(n) = 0.99 * se\ (n-1) + M(I(n-1)) \qquad (2)$$

$se(n)$ représentant le signal estimé pour l'échantillon courant, $se(n-1)$ le signal estimé de l'échantillon précédent, $M(I(n-1))$ étant le paramètre d'adaptation additif de l'indice de quantification de l'échantillon précédent.

Un exemple de réalisation quasi équivalent d'un facteur d'adaptation multiplicatif $M_m(I(n-1))$ avec facteur d'oubli pour calculer le signal estimé $se_m(n)$ est donné par l'équation (3) :

$$se_m(n) = se_m(n-1)^{0.99} * M_m(I(n-1)) \qquad (3)$$

où les valeurs des paramètres d'adaptation multiplicatifs $M_m(I(n-1))$ doivent avantageusement respecter les contraintes déjà mentionnées : elles sont inférieures à 1 pour les indices correspondant à une valeur quantifiée d'amplitude faible et supérieures à 1 pour les indices correspondant à une valeur quantifiée d'amplitude forte. De plus, elles augmentent d'une façon monotone.

Les propriétés des signaux estimés $se(n)$ et $se_m(n)$ obtenus selon les équations 2 et 3 sont équivalentes. On remarque que la complexité de calcul de l'équation (3) est supérieure à celle de l'équation 2, c'est pourquoi dans la réalisation privilégiée de l'invention on utilise les paramètres d'adaptation additifs. Dans la suite de ce document nous considérons toujours le signal estimé $se(n)$ obtenu en utilisant des paramètres d'adaptation additifs, mais les remarques sont également valables pour le signal estimé $se_m(n)$ obtenu en utilisant des paramètres d'adaptation multiplicatifs.

Le signal estimé $se(n)$ selon l'invention a des caractéristiques semblables à celles de la représentation du facteur d'échelle décodé d'un codeur de type G. 722 mais à la différence de celui-ci, ce n'est pas un signal décodé mais un signal déduit de façon simple à partir du flux binaire MICDA évitant ainsi des opérations coûteuses en complexité comme par exemple la vérification de saturation des valeurs. En effet, pour mettre en oeuvre la présente invention on n'a pas besoin de limiter l'utilisation des valeurs bornées représentées sur 16 bits, l'amplitude du signal estime $se(n)$ n'étant pas limitée.

Pour un codeur de type G.722, deux erreurs de prédiction sont codées et transmises dans le flux binaire: la première qui utilise 4, 5, ou 6 bits est destinée à représenter l'erreur de prédiction de la bande basse (de 0 à 4000Hz). La seconde erreur de prédiction, destinée à la bande haute (de 4000hz à 8000Hz), est toujours codée sur 2 bits.

Ainsi dans la bande basse d'un codeur de type G.722, l'erreur de prédiction est codée sur 4, 5 ou 6 bits en fonction du débit total (48, 56 ou 64 kbit/s respectivement). Pour que le codeur et le décodeur restent synchronisés, ils doivent utiliser le même facteur d'échelle. Le G.722 étant un codeur scalable, le débit peut être réduit au cours de la transmission. C'est pourquoi l'encodeur doit considérer que seul le plus bas débit sera disponible au décodeur. Pour ces raisons, dans le codeur et le décodeur G.722 l'adaptation du facteur d'échelle doit être faite à partir des indices du plus bas débit (48 kbit/s dont 32 kbit/s pour la bande basse, i.e. 4 bits par échantillon de la bande basse composés d'un bit de signe et de 3 bits pour choisir parmi les 8 amplitudes possibles du quantificateur scalaire).

Le signal estimé $se(n)$ selon l'invention n'est calculé ni à l'encodeur ni au décodeur mais entre les deux, donc sans contrainte de synchronisation. Ainsi, grâce au dispositif, le signal estimé $se(n)$ peut être calculé en utilisant tous les bits disponibles. Dans l'exemple d'un flux binaire G.722 bande basse on peut utiliser 3, 4 ou 5 bits d'indice d'amplitude $I(n)$ en fonction du débit actuel de codage (48, 56 ou 64 kbit/s respectivement) pour assurer une meilleure précision du signal estimé $se(n)$. A l'inverse, il est également possible de n'utiliser que des bits de poids fort de la bande basse, par exemple 3 sur les 5 reçus. Ainsi le dispositif selon la présente invention permet de choisir de façon flexible le meilleur compromis entre qualité et complexité en fonction des contraintes de l'application visée. Dans la suite nous considérons pour la simplicité des exemples donnés que l'indice de quantification d'amplitude $I(n)$ utilisé par le dispositif est codé sur 3 bits. L'invention couvre cependant également les débits plus élevés comme par exemple le codage G.722 à 56 kbits/s, où 16 amplitudes possibles dans la bande basse sont codées sur 4 bits (+ 1 bit de signe) ou à son débit de 64 kbit/s, utilisant 5 bits pour représenter l'amplitude de son quantificateur (32 niveaux possibles).

Dans les exemples de ce document nous notons $I(n)$ l'indice sur 3 bits pour coder les amplitudes $y(I(n))$ qui sont ordonnées selon leurs valeurs croissantes.

Le signal estimé $se(n)$ selon l'invention (comme par exemple le signal $se(n)$ selon l'équation 2) suit approximativement l'enveloppe temporelle du signal à coder. En effet l'énergie de l'erreur de prédiction codée par un codeur MIC est plus faible que celle du signal à coder ou du signal décodé (ces 2 derniers ont à peu près la même énergie). Le rapport entre l'énergie de l'erreur de prédiction MIC et celle du signal décodé dépend du gain de prédiction : pour un signal bien prédictif qui varie lentement le gain de prédiction est élevé et l'énergie de l'erreur de prédiction est faible.

Dans les zones non prédictives (comme par exemple le moment d'ouverture de la glotte pour le signal de la parole, une percussion, ou le pincement d'une corde pour la musique) le gain de prédiction est faible, et est proche de l'unité. L'énergie de l'erreur de prédiction est alors comparable à celle du signal à coder. Comme des zones prédictives et non prédictives varient régulièrement dans les signaux naturels, l'enveloppe temporelle de l'erreur de prédiction (ajustée sur les fortes valeurs des zones non prédictives) est à peu près proportionnelle avec celle du signal à coder. Pour les parties à forte énergie la quantification de l'erreur de prédiction nécessite plus souvent les plus forts niveaux du quantificateur, et selon le tableau 1 et l'équation 2 la valeur du signal estimé se(n) augmente fortement dans ces zones. Inversement, pour les parties de silence ou de faible bruit de fond bien prédictifs ce sont plutôt les plus faibles niveaux du quantificateur qui seront utilisés, la valeur du signal estimé se(n) diminuant alors. Ainsi le signal estimé se(n) selon l'invention suit approximativement l'allure du signal codé, et permet de différencier les zones actives du bruit. De plus, pour un signal de parole voisé l'ouverture périodique de la glotte introduit des zones non prédictives de façon périodique ce qui entraine des augmentations périodiques dans le signal estimé se(n) donc en analysant la valeur du signal estimé se(n) on constate une forte augmentation correspondant aux moments d'ouverture de la glotte.

Le signal estimé se(n) est donc suffisant pour détecter plusieurs caractéristiques non codées du signal.

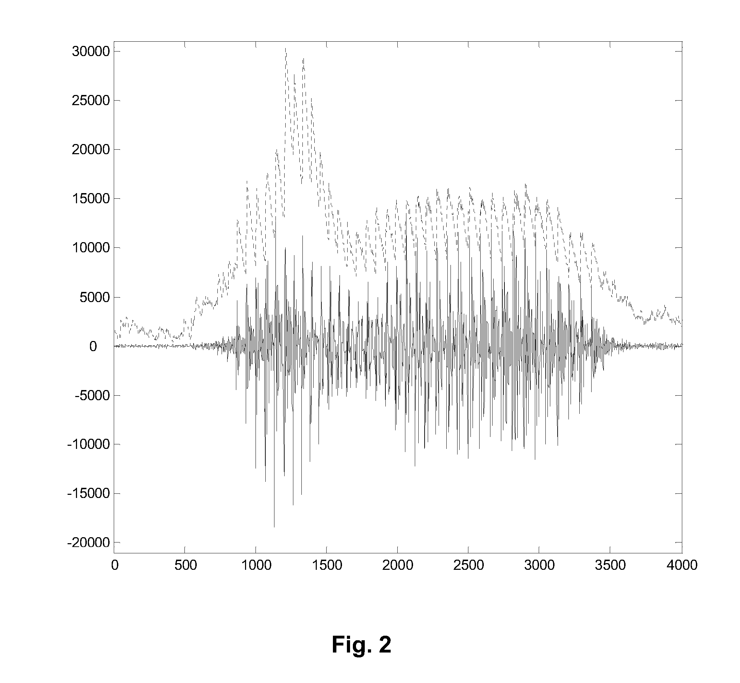

En effet, lorsqu'on compare, ce signal estimé et le signal audio à coder sur la **figure 2,** on peut voir qu'à partir de ce signal estimé, il est possible de déterminer des paramètres propres au signal audio et qui n'ont pas été codés par le codage MICDA, comme par exemple, son énergie ou sa périodicité à long terme. Sur cette figure la ligne continue représente le signal à coder, la ligne en pointillé représente le signal estimé se(n) obtenu en utilisant le tableau 1 et l'équation 2, mis à l'échelle (30*se(n)) pour faciliter la comparaison des deux courbes.

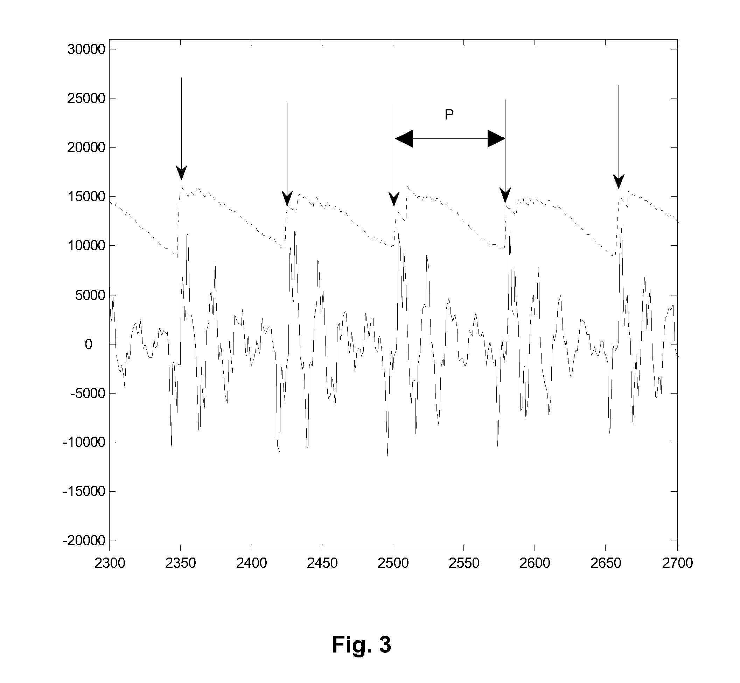

La **figure 3** magnifie la zone des indices temporels 2300 à 2700 de la figure 2.

Sur cette figure les flèches marquent les moments d'ouverture de la glotte (moments de soudaines augmentations de la valeur du signal estimé), la distance entre 2 flèches donne le pitch actuel du signal, période par période. Un exemple marqué par 'P' sur la figure est également donné. La période fondamentale (pitch) du signal peut être également déterminée pour une zone de signal par exemple en calculant la fonction d'autocorrélation du signal estimé et en cherchant son maximum.

La détermination de ce signal estimé est d'une complexité réduite puisqu'elle repose sur des opérations simples de lecture de tables, de multiplication et d'addition par échantillon, selon la formule (2) définie précédemment. D'après la recommandation de l'UIT-T G. 191 annexe A indiquant les coûts des opérations implémentées sur les processeurs cibles, les opérations nécessaires à la mise en oeuvre de ce système ne sont composées, par échantillon, que de deux accès mémoires et d'un MAC (multiplication directement suivie d'une addition, cette dernière est souvent implémentée comme opération de base dans les processeurs récents).

Pour revenir à la figure 1, l'étape E102 détermine par le module d'analyse « PARAM. », les paramètres représentatifs du signal codé, à partir de ce signal estimé.

L'analyse de ce signal estimé permet d'obtenir plusieurs types d'information sur le signal codé comme par exemple :

-  une estimation de l'énergie du signal ;
-  une estimation d'activité vocale ;
-  une classification du signal entre signal voisé et non voisé ;
-  une détection des transitions entre signal voisé et non voisé ;
-  une estimation de la périodicité du signal voisé (période fondamentale ou pitch) ;
-  une estimation des positions des impulsions glottiques.

La vitesse de variation de l'énergie du signal et la fréquence des périodes non actives (silence) donne également des informations sur la nature du signal codé (par exemple parole ou musique).

Cette liste n'est pas exhaustive et peut être complétée en fonction des traitements envisagés sur le signal codé.

En fonction du traitement qui est fait à l'étape E103 par le module de traitement « T$^t$ », les paramètres à déterminer en E102 ne sont pas les mêmes.

Pour un traitement de type discrimination de contenu ou de voix les paramètres de périodicité à long terme, "de pitch" voire de classification du signal peuvent être utiles.

Dans un système de forum de discussions vocales sur internet réservé aux enfants, une estimation de la périodicité du signal vocal dit "pitch" dans le domaine codé pourrait s'avérer intéressant pour alerter de la connexion d'un intervenant dont le "pitch" ne correspondrait pas à celui d'un enfant. Ainsi, en utilisant le paramètre de périodicité obtenu à partir du signal estimé, le dispositif de traitement selon l'invention peut discriminer la voix d'un enfant de celle d'un adulte. La détection d'un intervenant a priori adulte pourrait ainsi faire remonter une alerte au modérateur qui pourra décider du bannissement de l'intrus ou un traitement automatique pourra réduire au silence la voix indésirable dans le domaine codé en remplaçant le flux binaire correspondant par un flux binaire qu'on obtient en codant du silence. L'utilisation du système pour déterminer le genre de voix utilisée par l'intervenant présentera un gain en complexité conséquent, puisqu'il ne nécessitera plus le décodage de tous les flux arrivant au modérateur pour effectuer une analyse de pitch.

Dans un autre système l'analyse de la périodicité à long terme du signal estimé permettra de détecter le type de contenu (parole ou musique) et pourra proposer d'ajuster automatiquement le volume du signal dans le domaine codé pour éviter l'ajout de retard ou une dégradation de la communication dus à l'utilisation d'un tandem (décodage du signal, modification de son contenu dans le domaine codé puis re-encodage du signal modifié).

Dans un autre système, en cas de détection de non activité vocale, on pourra réduire au silence le signal décodé directement depuis le domaine codé en remplaçant le flux binaire correspondant par un flux binaire qu'on obtient en codant du silence. Dans une autre variante, en cas de détection de non activité vocale, on pourra remplacer le signal décodé par un bruit de confort en remplaçant le flux binaire correspondant par un flux binaire qu'on obtient en codant le bruit souhaité par exemple à un niveau plus faible.

A l'issue de l'étape E103, le flux binaire traité I'(n) est envoyé en sortie du dispositif de traitement 120 vers un décodeur MICDA 130 qui n'a pas besoin d'effectuer de traitements supplémentaires (comme par exemple le remplacement d'une voix par un silence). Ce décodeur peut alors fonctionner de façon indépendante et décode le flux binaire de façon classique sans être informé de l'éventuel traitement effectué par le dispositif.

A la sortie de ce décodeur 130, le signal décodé x'(n) est obtenu.

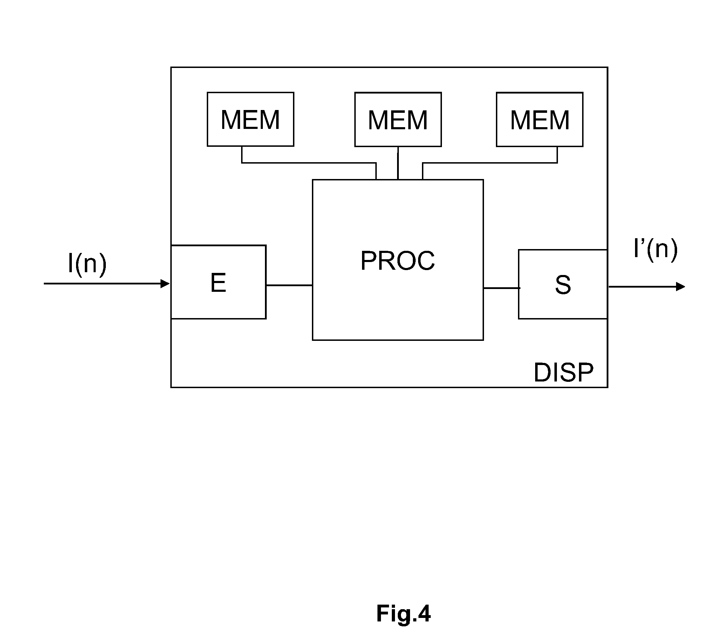

En référence à la **figure 4,** on a décrit un dispositif matériel adapté pour réaliser un dispositif de traitement selon un mode de réalisation de la présente invention.

Ce dispositif DISP a l'architecture d'un ordinateur conventionnel ou encore une architecture d'un serveur ou d'une passerelle de communication par exemple.

Il comporte une entrée E pour recevoir un signal numérique codé sous forme de flux binaire I(n).

Le dispositif comporte également un processeur PROC de signaux numériques adapté pour réaliser des opérations de traitement sur le flux binaire reçu.

Ce processeur est relié à une ou plusieurs unités de mémoire MEM adaptées pour stocker des informations nécessaires au pilotage du dispositif pour le traitement. Par exemple, ces unités de mémoire comportent des instructions pour la mise en oeuvre du procédé de traitement décrit ci-avant et notamment pour mettre en oeuvre les étapes de détermination d'un signal estimé à partir des indices de quantification du flux binaire, de détermination de paramètres non codés représentatifs dudit signal audio, à partir dudit signal estimé et de traitement dudit signal audio codé en utilisant les paramètres déterminés.

Ces unités de mémoire peuvent également comporter des tables de valeurs de quantification, des tables de paramètres d'adaptation ou autres paramètres de calcul nécessaires pour la mise en oeuvre du procédé de traitement.

De manière plus générale, un moyen de stockage, lisible par un processeur, intégré ou non au dispositif de traitement, éventuellement amovible, mémorise un programme informatique mettant en oeuvre un procédé de traitement selon l'invention. Le bloc 120 de la figure 1 peut par exemple illustrer l'algorithme d'un tel programme informatique.

Le processeur est également adapté pour stocker des résultats dans ces unités de mémoire. Enfin, le dispositif comporte une sortie S reliée au processeur pour fournir un signal de sortie sous la forme d'un flux binaire traité I'(n).

## Revendications

1. Procédé de traitement d'un signal audio codé en un flux binaire par un codage prédictif de type MICDA, **caractérisé en ce qu'**il comporte les étapes suivantes:

   - détermination (E101) d'un signal estimé se à partir des indices de quantification I du flux binaire, la détermination étant effectuée pour un échantillon courant n par:

     - obtention d'un paramètre d'adaptation M(I(n-1)) associé à l'indice de quantification pour l'échantillon précédent I(n-1) ;
     - calcul d'un signal estimé pour l'échantillon courant se(n) à partir du paramètre d'adaptation déterminé M(I(n-1)), du signal estimé pour l'échantillon précédent se(n-1) et d'un facteur d'oubli prédéfini V;
     - détermination (E102) de paramètres non codés représentatifs dudit signal audio, à partir dudit signal estimé se ;
     - traitement (E103) dudit signal audio codé en utilisant les paramètres déterminés.

**2.** Procédé selon la revendication 1, **caractérisé en ce que** le paramètre d'adaptation M est défini dans une étape préalable, de telle sorte que sa valeur respecte la propriété d'accroissement monotone avec les valeurs quantifiées d'amplitude correspondant aux indices de quantification I.

**3.** Procédé selon la revendication 1, **caractérisé en ce que** le paramètre d'adaptation M est obtenu en temps réel par simple décalage binaire et soustraction à partir de l'indice de quantification I.

**4.** Procédé selon la revendication 2, **caractérisé en ce que** le signal estimé est déterminé selon l'équation :

$$se(n) = V * se(n-1) + M(I(n-1))$$

où se (n) représente le signal estimé pour l'échantillon courant, se(n-1) le signal estimé de l'échantillon précédent, M(I(n-1)) le paramètre d'adaptation en fonction de l'indice de quantification de l'échantillon précédent et V un facteur d'oubli avec une variable inférieure à 1.

**5.** Procédé selon la revendication 1, **caractérisé en ce que** les paramètres non codés sont déterminés à partir du signal estimé par une étape d'analyse et font partie de paramètres appartenant au groupe comprenant :

- l'énergie du signal audio ;
- la périodicité ou non du signal audio ;
- la classification du signal audio ;
- la longueur de la période fondamentale du signal audio ;
- la position temporelle des impulsions glottiques ;
- l'activité vocale.

**6.** Procédé selon la revendication 1, **caractérisé en ce que** le traitement du signal audio comprend une discrimination de locuteurs et en cas de détection d'une voix indésirable sa réduction au silence dans le domaine codé.

**7.** Procédé selon la revendication 1, **caractérisé en ce que** le traitement du signal audio comprend une détection de non activité vocale et le remplacement du flux binaire correspondant par un flux binaire obtenu par codage d'un bruit de confort.

**8.** Dispositif de traitement d'un signal audio codé en un flux binaire par un codage prédictif de type MICDA, **caractérisé en ce qu'**il comporte :

- un module (EST.) de détermination d'un signal estimé se à partir des indices de quantification I du flux binaire, apte à mettre en oeuvre les étapes suivantes, pour un échantillon courant n:

- obtention d'un paramètre d'adaptation M(I(n-1)) associé à l'indice de quantification pour l'échantillon précédent I(n-1) ;
- calcul d'un signal estimé pour l'échantillon courant se(n) à partir du paramètre d'adaptation déterminé M(I(n-1)), du signal estimé pour l'échantillon précédent se(n-1) et d'un facteur d'oubli prédéfini V;

- un module (PARAM.) d'analyse pour déterminer des paramètres non codés représentatifs dudit signal audio, à partir dudit signal estimé se;
- un module (T$^t$) de traitement dudit signal audio codé en utilisant les paramètres déterminés.

**9.** Passerelle de communication **caractérisée en ce qu'**elle comporte un dispositif selon la revendication 8.

**10.** Programme informatique comportant des instructions de code pour la mise en oeuvre des étapes du procédé de traitement selon l'une des revendications 1 à 7, lorsque ces instructions sont exécutées par un processeur.

**Patentansprüche**

1. Verfahren zum Verarbeiten eines codierten Audiosignals zu einem Bitstrom durch Prädikationscodierung der Art ADPCM, **dadurch gekennzeichnet, dass** es die folgenden Schritte umfasst:

   - Bestimmen (E101) eines geschätzten Signals se auf der Basis der Quantifizierungsstufen I des Bitstroms, wobei die Bestimmung für eine laufende Abtastung n durchgeführt wird, durch:

     - Erhalten eines Anpassungsparameters M(I(n-1)), welcher der Quantifizierungsstufe für die vorhergehende Abtastung I(n-1) zugeordnet ist;
     - Berechnen eines geschätzten Signals für die laufende Abtastung se(n) auf der Basis des bestimmten Anpassungsparameters M(I(n-1)), des geschätzten Signals für die vorhergehende Abtastung se(n-1), und eines zuvor definierten Vergessensfaktors V;

   - Bestimmen (E102) von nicht codierten repräsentativen Parametern des Audiosignals auf der Basis des geschätzten Signals se;
   - Verarbeiten (E103) des codierten Audiosignals unter Verwendung der bestimmten Parameter.

2. Verfahren nach Anspruch 1, **dadurch gekennzeichnet, dass** der Anpassungsparameter M in einem vorausgehenden Schritt dergestalt definiert wird, dass sein Wert die monotone Wachstumseigenschaft mit den quantifizierten Amplitudenwerten respektiert, die den Quantifizierungsstufen I entsprechen.

3. Verfahren nach Anspruch 1, **dadurch gekennzeichnet, dass** der Anpassungsparameter M in Echtzeit durch einfache binäre Verschiebung und Subtraktion auf der Basis der Quantifizierungsstufe I erhalten wird.

4. Verfahren nach Anspruch 2, **dadurch gekennzeichnet, dass** das geschätzte Signal gemäß der Gleichung bestimmt wird:

$$se(n) = V * se(n-1) + M(I(n-1))$$

wobei se(n) das geschätzte Signal für die laufende Abtastung, se(n-1) das geschätzte Signal der vorhergehenden Abtastung, M(I(n-1)) den Anpassungsparameter in Abhängigkeit von der Quantifizierungsstufe der vorhergehenden Abtastung und V einen Vergessensfaktor mit einer Variablen kleiner als 1 repräsentiert.

5. Verfahren nach Anspruch 1, **dadurch gekennzeichnet, dass** die nicht codierten Parameter auf der Basis des geschätzten Signals durch einen Analyseschritt bestimmt werden und Bestandteil von Parametern sind, die zu der Gruppe gehören, die Folgendes aufweist:

   - die Energie des Audiosignals;
   - die Periodizität des Audiosignals oder nicht;
   - die Klassifizierung des Audiosignals;
   - die Länge der Grundperiode des Audiosignals;
   - die zeitliche Anordnung der Glottisimpulse;
   - die Sprachaktivität.

6. Verfahren nach Anspruch 1, **dadurch gekennzeichnet, dass** die Verarbeitung des Audiosignals eine Unterscheidung der Sprechenden und, bei Erfassung einer unerwünschten Stimme, deren Reduzierung auf Geräuschlosigkeit in dem codierten Bereich aufweist.

7. Verfahren nach Anspruch 1, **dadurch gekennzeichnet, dass** die Verarbeitung des Audiosignals eine Erfassung, wenn keine Sprachaktivität vorliegt, und die Ersetzung des entsprechenden Bitstroms durch einen Bitstrom aufweist, der durch Codierung eines Komfortrauschens erhalten wird.

8. Verarbeitungsvorrichtung eines codierten Audiosignals zu einem Bitstrom durch eine Prädikationscodierung der Art ADPCM, **dadurch gekennzeichnet, dass** sie Folgendes umfasst:

- ein Bestimmungsmodul (EST.) eines geschätzten Signals se auf der Basis der Quantifizierungsstufen I des Bitstroms, das in der Lage ist, die folgenden Schritte für eine laufende Abtastung n anzuwenden:

- Erhalten eines Anpassungsparameters M(I(n-1)), welcher der Quantifizierungsstufe für die vorhergehende Abtastung I(n-1) zugeordnet ist;
- Berechnen eines geschätzten Signals für die laufende Abtastung se(n) auf der Basis des Anpassungsparameters M(I(n-1)), des geschätzten Signals für die vorhergehende Abtastung se(n-1) und eines zuvor definierten Vergessensfaktors V;

- ein Analysemodul (PARAM.), um nicht codierte repräsentative Parameter des Audiosignals auf der Basis des geschätzten Signals se zu bestimmen;
- ein Verarbeitungsmodul (T$^t$) des codierten Audiosignals unter Verwendung der bestimmten Parameter.

9. Kommunikationsgateway, **dadurch gekennzeichnet, dass** er eine Vorrichtung gemäß Anspruch 8 umfasst.

10. Informatikprogramm, das Codeanweisungen für den Einsatz der Schritte des Verarbeitungsverfahrens gemäß einem der Ansprüche 1 bis 7 umfasst, wenn diese Anweisungen durch einen Prozessor ausgeführt werden.


**Claims**

1. Method for processing a coded audio signal in a bitstream by a predictive coding of ADPCM type, **characterized in that** it comprises the following steps:

determination (E101) of an estimated signal se on the basis of the quantization indices of the bitstream, the determination being carried out for a current sample n:

- obtaining of an adaptation parameter M(I(n-1)) associated with the quantization index for the previous sample (I(n-1);
- calculation of an estimated signal for the current sample se(n) on the basis of the adaptation parameter determined M(I(n-1)), of the signal estimated for the previous sample se(n-1) and of a predefined forget factor V;
- determination (E102) of uncoded parameters representative of said audio signal, on the basis of said estimated signal se;
- processing (E103) of said coded audio signal using the parameters determined.

2. Method according to Claim 1, **characterized in that** the adaptation parameter M is defined in a prior step, in such a way that its value complies with the property of monotonic increase with the quantized amplitude values corresponding to the quantization indices I.

3. Method according to Claim 1, **characterized in that** the adaptation parameter is obtained in real time by simple binary shifting and subtraction on the basis of the quantization index I.

4. Method according to Claim 2, **characterized in that** the estimated signal is determined according to the equation:

```
se(n) = V * se(n-1) + M(I(n-1))
```

where se (n) represents the signal estimated for the current sample, se(n-1) the estimated signal of the previous sample, M(I(n-1)) the adaptation parameter as a function of the quantization index of the previous sample and V a forget factor with a variable less than 1.

5. Method according to Claim 1, **characterized in that** the uncoded parameters are determined on the basis of the signal estimated by an analysis step and form part of parameters belonging to the group comprising:

- the energy of the audio signal;
- the periodicity or otherwise of the audio signal;
- the classification of the audio signal;
- the length of the fundamental period of the audio signal;
- the temporal position of the glottal pulses;
- the vocal activity.

6. Method according to Claim 1, **characterized in that** the processing of the audio signal comprises a discrimination of speakers and in the case of detection of an undesirable voice its reduction to silence in the coded domain.

7. Method according to Claim 1, **characterized in that** the processing of the audio signal comprises a detection of vocal inactivity and the replacement of the corresponding bitstream by a bitstream obtained by coding of a comfort noise.

8. Device for processing a coded audio signal in a bitstream by a predictive coding of ADPCM type, **characterized in that** it comprises:

- a module (EST.) for determining an estimated signal se on the basis of the quantization indices I of the bitstream, capable of implementing the following steps, for a current sample n:
- obtaining of an adaptation parameter $M(I(n-1))$ associated with the quantization index for the previous sample $(I(n-1)$;
- calculation of an estimated signal for the current sample $se(n)$ on the basis of the adaptation parameter determined $M(I(n-1))$, of the signal estimated for the previous sample $se(n-1)$ and of a predefined forget factor V;
- an analysis module (PARAM.) for determining uncoded parameters representative of said audio signal, on the basis of said estimated signal se;
- a module ($T^t$) for processing said coded audio signal using the parameters determined.

9. Communication gateway **characterized in that** it comprises a device according to Claim 8.

10. Computer program comprising code instructions for the implementation of the steps of the processing method according to one of Claims 1 to 7, when these instructions are executed by a processor.

EP 2 691 953 B1

**Fig. 1**

Fig. 2

**Fig. 3**

Fig.4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2009010831 A

**Littérature non-brevet citée dans la description**

- **RAFILA K.S ; DAWOUD D.S.** Voice/unvoiced/mixed excitation classification of speech using the autocorrelation of the output of an ADPCM system. *Systems Engineering,* 1989